# DEMANDE DE BREVET EUROPEEN

(11) **EP 2 418 609 A1**
(43) Date de publication de la demande: **15.02.2012**
(21) Numéro de dépôt: 10305820.2
(22) Date de dépôt: 23.07.2010
(51) Int. Cl.: G06K 19/077

(54) **Module électronique sécurisé, dispositif à module électronique sécurisé et procédé de fabrication**

(71) Demandeur: Gemalto SA, 92190 Meudon (FR)
(72) Inventeur: OTTOBON, Stéphane, 92197, MEUDON (FR)
(74) Mandataire: Cour, Pierre

(57) **Abrégé**

La présente invention concerne un module électronique sécurisé 1 comportant un film support diélectrique 3 ayant au moins une zone de contact électrique 5 sur une face, et ayant sur la face opposée une puce électronique 7 reliée à ladite au moins une zone de contact électrique 5. Ledit film support 3 présente des surfaces développées 7 en dehors du plan général du film support 3 pour augmenter la surface d'adhésion dudit module électronique 1. Lesdites surfaces développées 7 étant situées sur la zone périphérique dudit module électronique 1.

## Description

La présente invention se rapporte au domaine technique des modules électroniques, aux procédés de fabrication d'un module électronique, ainsi qu'aux dispositifs électroniques, en particulier aux cartes à puces, comportant au moins un module électronique. Plus précisément, l'invention ce rapporte aux modules électroniques sécurisés.

De façon générale, les modules électroniques sont formés par un film support diélectrique sur lequel est laminée une couche métallisée. Sur la face opposée à la couche métallisée est collée une puce électronique connectée à différentes zones de la couche métallisée.

Dans un dispositif électronique, le module électronique est collé dans une cavité prévue à cet effet dans le corps du dispositif.

Ce genre de module électronique trouve application notamment dans les cartes à puces.

Cependant, les normes concernant le paiement électronique notamment par cartes bancaires ou concernant les pièces d'identité électroniques, demandent une plus grande inviolabilité mécanique en particulier le fait que l'on ne puisse retirer le module électronique pour le réutiliser par la suite.

Une solution consiste à réaliser un collage structural ou par ancrage mécanique de la puce dans une résine solidaire du fond de la cavité du corps du dispositif. Ainsi, lors d'une tentative de démontage du module électronique, la puce est solidaire de la résine et reste dans la cavité du corps du dispositif électronique et est donc déconnectée de la couche métallisée. Le démontage du module électronique pour une réutilisation ultérieure est donc rendu impossible.

Cependant, pour certain matériaux de corps de dispositif, comme le polycarbonate (PC) ou le polyéthylène téréphtalate (PET) couramment utilisé actuellement, le collage par résine est plus délicat étant donné une plus faible adhérence et donc les risques de démontage du module électronique pour une utilisation frauduleuse sont plus importants.

Un des buts de la présente invention est donc de proposer un module électronique sécurisé, pouvant être utilisé efficacement avec le plus grand nombre de matériaux de corps de dispositif électroniques possible, tels que les cartes à puces.

Ainsi la présente invention concerne un module électronique sécurisé comportant un film support diélectrique ayant au moins une zone de contact électrique sur une face, et ayant sur la face opposée une puce électronique reliée à ladite au moins une zone de contact électrique par l'intermédiaire d'au moins une connectique traversant au moins un orifice du film support, ledit film support présentant des surfaces développées en dehors du plan général du film support pour augmenter la surface d'adhésion dudit module électronique, lesdites surfaces développées étant situées sur la zone périphérique dudit module électronique.

L'ajout de ces surfaces développées augment la surface du film de support diélectrique et donc le module électronique peut être collé plus efficacement par exemple à un dispositif électronique comme une carte à puce.

Un module électronique comprend généralement sur sa face comprenant la puce électronique deux zones. Une première zone contient la puce électronique en elle même ainsi que ses connexions avec la ou les zones de contact électrique et une zone périphérique destinée à assurer l'adhésion du module électronique lors de sa mise en place dans un dispositif électronique tel qu'une carte à puce.

Selon une variante, la puce électronique et ses connectiques sont encapsulés dans une résine protectrice.

Selon différents modes de réalisation de l'invention, les surfaces développées peuvent être en creux par rapport au film support. Les surfaces développées peuvent être des évidements du film support. Les évidements peuvent être traversant et peuvent avoir comme fond la couche de métallisation formant la zone de contact électrique. Les évidements du film support peuvent être borgnes.

L'invention concerne également un procédé de fabrication d'un module électronique sécurisé comportant un film support diélectrique ayant au moins une zone de contact électrique sur une face, et ayant sur la face opposée une puce électronique reliée à ladite au moins une zone de contact électrique par l'intermédiaire d'au moins une connectique traversant au moins un orifice du film support, ledit procédé comportant une étape de réalisation de surfaces développées en dehors du plan général pour augmenter la surface d'adhésion dudit module électronique, lesdites surfaces développées étant situées sur la zone périphérique dudit module électronique.

Selon différentes variantes, l'étape de réalisation des surfaces développées sur le film support peut être effectuée avant la mise en place de la ou des zones de contact électrique. Egalement, L'étape de réalisation des surfaces développées peut être une étape de réalisation d'évidements sur le film support. L'étape de réalisation des évidements peut être réalisée par poinçonnage. L'étape de réalisation des surfaces développées sur le film support peut être effectuée après la mise en place de la ou des zones de contact électrique. L'étape de réalisation d'évidement peut être réalisée par perçage laser.

L'invention concerne également un dispositif électronique comprenant au moins un module électronique comportant un film support diélectrique ayant au moins une zone de contact électrique sur une face, et ayant sur la face opposée une puce électronique reliée à ladite au moins une zone de contact électrique par l'intermédiaire d'au moins une connectique traversant au moins un orifice du film support, ledit film support présentant des surfaces développées en dehors du plan général pour augmenter la surface d'adhésion dudit module électronique, lesdites surfaces développées étant situées sur la zone périphérique dudit module électronique.

Préférentiellement, ledit dispositif est une carte à puce.

D'autres caractéristiques et avantages de l'invention apparaîtront plus clairement à la lecture de la description suivante, donnée à titre d'exemple illustratif et non limitatif, et des dessins annexés parmi lesquels :
- la figure 1 représente un schéma simplifié d'un exemple de dispositif électronique, en vue de dessus,
- La figure 2 représente un schéma simplifié d'un exemple de module électronique dans un dispositif électronique, en vue de coupe et de côté,
- La figure 3 représente un schéma simplifié d'un exemple de module électronique, en vue de dessous.

Les éléments identiques sur toutes les figures sont indiqués par les mêmes numéros de références.

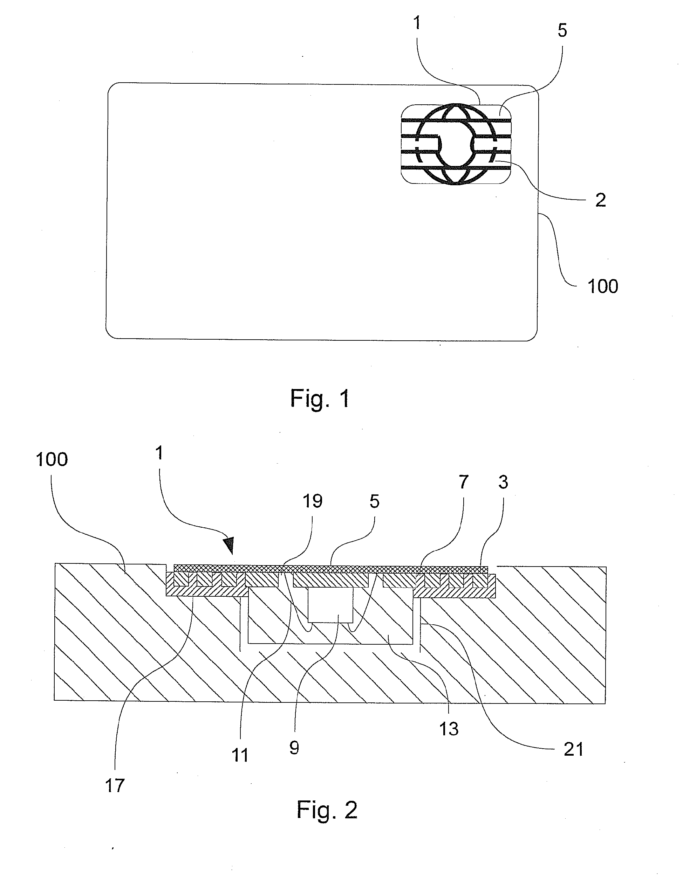

La figure 1 représente un schéma simplifié d'un exemple de dispositif électronique 100, ici une carte à puce, en vue de dessus, dans lequel a été mis en place un module électronique 1.

On y voit, au niveau du module électronique 1, plusieurs zones de contact électrique 5 réalisés par exemples par métallisation sur un film support diélectrique 3. La métallisation peut être réalisée par lamination d'une feuille de cuivre sur une feuille de substrat. Les zones de contact électrique 5 sont séparées les unes des autres par exemple par des zones ou bandes non métallisées 2. Les séparation de zone métalisées sont faites par attaque chimique du cuivre. Il s'agit de zones ou bandes ou le film support diélectrique rigide 3 est à nu.

La figure 2 montre un schéma simplifié d'un exemple de module électronique 1 dans un dispositif électronique 100, par exemple une carte à puce, en vue de coupe et de côté.

On retrouve ici le film support 3 comportant sur sa face supérieure une zone de contact électrique 5. Sur la face inférieure, opposée à celle comportant la zone de contact électrique 5, le film de support 3 comporte une puce électronique 9, reliée par des connectiques 11 à la couche métallisée 5. Les connectiques 11 peuvent, comme représenté sur la figure 2, être reliées à la zone de contact électrique 5 par des orifices 19 au travers du film support 1.

La puce électronique 9, les connectiques 11 ainsi que les orifices 19 définissent une première zone, ou zone centrale, du film support 3. Cette première zone peut être recouverte d'une capsule de résine 13, englobant la puce électronique 9, les connectiques 11 et les orifices 19, afin de les protéger des agressions extérieures.

Une seconde zone, ou zone périphérique, permet l'adhésion du module électronique 1 sur le dispositif électronique 100 au moyen d'un adhésif 17.

Dans l'exemple présenté par la figure 2, le module électronique est mis en place dans une cavité 21 prévue à cet effet.

Le film support 3 comporte des surfaces développées 7 en dehors de son plan général. Ces surfaces développées 7 sont situées dans la zone périphérique du module électronique 1 et augmentent la surface d'adhésion entre l'adhésif 17 et le module électronique 1 et donc augmentent également la force d'adhésion entre le module électronique 1 et le dispositif électronique 100.

Ainsi, lors d'une tentative d'extraction du module électronique 1, du fait de la forte adhésion entre le film support 3 et le dispositif électronique 100, ledit film support 3 se détruit mécaniquement. En effet, des morceaux du film support 3 peuvent rester dans l'adhésif 17, rendant une utilisation ultérieure du module électronique 1 impossible.

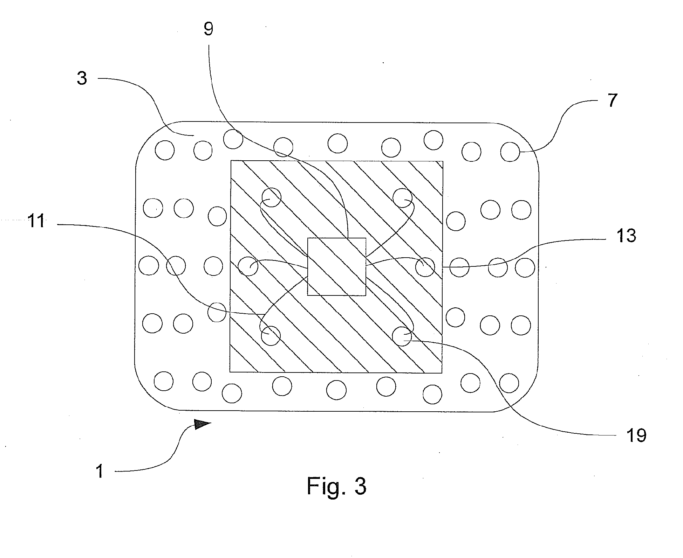

Selon une variante, les surfaces développées 7 peuvent être en creux par rapport au film support 3. Par exemple, ces surfaces développées 7 peuvent être des évidements du film support 3 dans la zone périphérique du module électronique 1, comme cela est représenté par les figures 2 et 3.

Ces évidements 7 peuvent être borgnes et avoir une profondeur inférieure à l'épaisseur du film support 3.

Ces évidements 7 peuvent également traverser complètement le film support 3 pour avoir comme fond la couche métallisée formant la zone de contact électrique 5.

Lors de la mise en place du module électronique 1 dans la cavité 21, l'adhésif 17 pénètre dans les évidements 7 du film support 3. Cela augmente la surface de contact entre le film support 3 et l'adhésif, améliorant de fait l'adhésion entre ces ledit film support 3 et le dispositif électronique 100.

L'adhésion est d'autant plus améliorée que les parois des évidements 7 ne sont pas lisses mais rugueuses, notamment si ils ont été faites mécaniquement. Si le film support 3 est par exemple en verre-époxy, toutes les fibres le composant sont alors coupées et sont comme des micros cils d'accroche, augmentant encore plus l'adhésion.

Les évidements 7, outre le fait d'augmenter la surface d'adhésion, jouent également le rôle de point fort d'ancrage mécanique lorsque l'adhésif 17 pénètre à l'intérieur de ces derniers, augmentant encore plus l'adhésion entre le module électronique 1 et le dispositif électronique 100.

Un autre effet des évidements 7 est un renforcement de l'adhésion du au fait que l'adhésif 17 est en contact avec différents matériaux, notamment lorsque les perforations 7 traversent le film support 3 et ont comme fond le métal de la zone de contact électrique 5. L'adhésif est alors en contact avec le film support 3, la couche métallisée formant la zone de contact électrique 5 et l'adhésif maintenant ladite couche métallisée sur le film support 3.

La quantité d'adhésif 17 présent dans la cavité 21 du dispositif électronique 100 lors de la mise en place du module électronique 1 peut-être optimisée et calculée afin de bien fluer et de remplir complètement les évidements 7. De plus la forme, le diamètre et de nombres desdits évidements 7 peut varier afin de présenter la meilleure adhésion entre le dispositif électronique 100 et le module électronique 1.

Dans le cas ou lesdits évidements 7 traversent totalement le film support 3, ils diminuent la surface de contact entre la ou les zones de contact électrique 5 et le film support 3. Ainsi, lors d'une tentative d'extraction du module électronique 1, ledit film support 3 reste collé au dispositif électronique 100 et la zone de contact électrique 5 se détache du film support 3, détruisant ou détériorant ainsi le module électronique 1, le rendant inutilisable ultérieurement.

Lorsque les surfaces développées 7 sont réalisées lors de la fabrication du module électronique 1. Le procédé de fabrication dudit module électronique 1 comprend donc une étape supplémentaire de réalisation des surfaces développées 7.

En variante, les surfaces développées 7 peuvent être réalisées au moment de la fabrication du film support 3, par exemple par poinçonnage dans le cas d'évidements traversant le film support 3. Dans ce cas ces évidements 7 peuvent être réalisés en même temps que les orifices 19 traversant le substrat pour permettre le passage des conducteurs électriques 11.

Les surfaces développées 7 peuvent également être réalisées plus tardivement dans le processus de fabrication du module électronique 1, après que la ou les zones de contact électrique 5 aient été mises en place par exemple.

Les surfaces développées 7 peuvent également être réalisées, dans le cas d'évidements sur le film support 3, par perçage laser, permettant ainsi d'obtenir la profondeur d'évidement désirée.

Ainsi, en agissant sur l'adhésion du module électronique en définissant surfaces développées augmentant cette adhésion, il est possible à moindre coût d'obtenir un module électronique sécurisé contre un démontage frauduleux, étant donné qu'une tentative de démontage conduit à la destruction au moins partielle du module électronique et rend ce dernier inopérant et inutilisable ultérieurement.

## Revendications

1. Module électronique sécurisé (1) comportant un film support diélectrique (3) ayant au moins une zone de contact électrique (5) sur une face, et ayant sur la face opposée une puce électronique (7) reliée à ladite au moins une zone de contact électrique (5) par l'intermédiaire d'au moins une connectique (11) traversant au moins un orifice (19) du film support, **caractérisé en ce que** ledit film support (3) présente des surfaces développées (7) en dehors du plan général du film support (3) pour augmenter la surface d'adhésion dudit module électronique (1), lesdites surfaces développées (7) étant situées sur une zone périphérique dudit module électronique (1).

2. Module électronique (1) selon la revendication 1, dans lequel la puce électronique (9) et ses connectiques (11) sont encapsulés dans une résine protectrice (13).

3. Module électronique (1) selon la revendication 1, dans lequel les surfaces développées (7) sont en creux par rapport au film support (3).

4. Module électronique (1) selon la revendication 3, dans lequel les surfaces développées (7) sont des évidements du film support (3).

5. Module électronique (1) selon la revendication 4, dans lequel les évidements (7) sont traversant et ont comme fond la couche de métallisation formant la zone de contact électrique (5).

6. Module électronique (1) selon la revendication 4, dans lequel les évidements (7) du film support (3) sont borgnes.

7. Procédé de fabrication d'un module électronique sécurisé (1) comportant un film support diélectrique (3) ayant au moins une zone de contact électrique (5) sur une face, et ayant sur la face opposée une puce électronique (7) reliée à ladite au moins une zone de contact électrique (5) par l'intermédiaire d'au moins une connectique (11) traversant au moins un orifice (19), **caractérisé en ce que** ledit procédé comporte une étape de réalisation de surfaces développées (7) en dehors du plan général pour augmenter la surface d'adhésion dudit module électronique (1), lesdites surfaces développées (7) étant situées sur la zone périphérique dudit module électronique (1).

8. Procédé de fabrication selon la revendication 7, dans lequel l'étape de réalisation de surfaces développées (7) sur le film support (3) est effectuée avant la mise en place de la ou des zones de contact électrique (5).

9. Procédé de fabrication selon l'une la revendication 7, dans lequel l'étape de réalisation des surfaces développées (7) est une étape de réalisation d'évidement sur le film support (3).

10. Procédé de fabrication selon la revendication 9, dans lequel l'étape de réalisation des évidements est réalisée par poinçonnage.

11. Procédé de fabrication selon la revendication 8, dans lequel l'étape de réalisation de surfaces développées (7) sur le film support (3) est effectuée après la mise en place de la ou des zones de contact électrique (5).

12. Procédé de fabrication la revendication 11, dans lequel l'étape de réalisation des évidements est réalisée par perçage laser.

13. Dispositif électronique (100) comprenant au moins un module électronique (1) comportant un film support diélectrique (3) ayant au moins une zone de contact électrique (5) sur une face, et ayant sur la face opposée une puce électronique (7) reliée à ladite au moins une zone de contact électrique (5) par l'intermédiaire d'au moins une connectique (11) traversant au moins un orifice (19), **caractérisé en ce que** ledit film support (3) présente des surfaces développées (7) en dehors du plan général pour augmenter la surface d'adhésion dudit module électronique (1), lesdites surfaces développées (7) étant situées sur la zone périphérique dudit module électronique (1).

14. Dispositif électronique (100) selon la revendication 13, dans lequel ledit dispositif est une carte à puce.
